# EUROPEAN PATENT APPLICATION

(11) **EP 4 492 436 A1**
(43) Date of publication of application: **15.01.2025**
(21) Application number: 23784317.2
(22) Date of filing: 06.04.2023
(51) Int. Cl.: H01L 21/60

(54) **PHASE-CHANGE STORAGE MATERIAL AND PREPARATION METHOD THEREFOR, PHASE-CHANGE STORAGE CHIP AND DEVICE**

(30) Priority: 06.04.2022 CN 202210356787
(71) Applicant: Huawei Technologies Co., Ltd., Shenzhen, Guangdong 518129 (CN)
(72) Inventor: CHEN, Xin, Shenzhen, Guangdong 518129 (CN); LI, Xiang, Shenzhen, Guangdong 518129 (CN)
(74) Representative: Maiwald GmbH
(86) International application number: PCT/CN2023/086543
(87) International publication number: WO 2023/193754

(57) **Abstract**

This application relates to the field of data storage technologies, and specifically, to a phase-change memory material, a preparation method thereof, a phase-change memory chip, and a device. The phase-change memory material includes a material shown by TiₐSb_{b}Te_{c}D_{d}, where a represents an atom percent of Ti, b represents an atom percent of Sb, c represents an atom percent of Te, d represents an atom percent of an element D, and a+b+c+d=1; 3%≤a≤45%, and 0.5≤(b:c)≤3; and D is a doping element, and 0≤d≤15%.The phase-change memory material has low operation power consumption and a low operation delay.

## Description

This application claims priority to Chinese Patent Application No. 202210356787.X, filed with the China National Intellectual Property Administration on April 6, 2022 and entitled "PHASE-CHANGE MEMORY MATERIAL, PREPARATION METHOD THEREOF, PHASE-CHANGE MEMORY CHIP, AND DEVICE", which is incorporated herein by reference in its entirety.

### TECHNICAL FIELD

This application relates to the field of data storage technologies, and specifically, to a phase-change memory material, a preparation method thereof, a phase-change memory chip, and a device.

### BACKGROUND

Development of information technologies imposes requirements of a low delay and a large capacity for a memory. The low delay helps increase a data processing speed. The large capacity helps improve storage density and save memory manufacturing costs.

As a nonvolatile memory, a phase-change memory (phase-change memory, PCM) has a high-density data storage capability and a fast erase and write speed, and has been used in an embedded memory and the like. However, the current phase-change memory cannot balance low power consumption and a low operation delay, and consequently has poor performance.

### SUMMARY

Embodiments of this application provide a phase-change memory material, a preparation method thereof, a phase-change memory chip, and a device, to reduce power consumption and an operation delay of the phase-change memory chip and the device.

According to a first aspect, a phase-change memory material is provided, where the phase-change memory material includes a material shown by a formula (1):

TiₐSb_{b}Te_{c}D_{d} (1), where

a represents an atom percent of Ti, b represents an atom percent of Sb, c represents an atom percent of Te, d represents an atom percent of an element D, and a+b+c+d=1; 3%≤a≤45%, and 0.5≤(b:c)≤3; and D is a doping element, and 0≤d≤15%.

The phase-change memory material provided in this embodiment of this application is a new Sb-Te-based phase-change memory material. When SbTe is crystallized, that is, in a crystalline state, the phase-change memory material is in a low resistance state; or when SbTe is amorphous, that is, in an amorphous state, the phase-change memory material is in a high resistance state. Different resistance states of the phase-change memory material may represent different information, to implement information storage. In addition, the information can be read by measuring the resistance state of the phase-change memory material.

The phase-change memory material includes the element Ti, where Ti and Te form a TiTe nucleation center. Specifically, bond strength between TiTe is greater than bond strength between SbTe. During conversion of SbTe between the crystalline state (that is, the low resistance state) and the amorphous state (that is, the high resistance state), the TiTe nucleation center can maintain a stable structure. When SbTe is converted from the crystalline state (that is, the low resistance state) to the amorphous state (that is, the high resistance state), TiTe, as the nucleation center, can accelerate conversion of SbTe from the crystalline state to the amorphous state, so that an operation delay can be reduced. Therefore, when the phase-change memory material is used in a storage-class memory, the storage-class memory can have a low delay.

In addition, a lattice mismatch degree between lattices of TiTe and SbTe is 12%, and the phase-change memory material includes Ti. This may cause lattice distortion or a lattice defect of the phase-change memory material, so that the phase-change memory material is converted from the crystalline state to the amorphous state more easily, and therefore, power consumption required for conversion from the crystalline state to the amorphous state can be reduced.

In addition, Ti included in the phase-change memory material can reduce a grain size of the phase-change memory material, so that grain size distribution is more uniform (which may be understood that a smaller grain size indicates a smaller grain size distribution range, and therefore, the grain size distribution is more uniform). Therefore, a fatigue life of the phase-change memory material can be improved.

In a possible implementation, a value range of the atom percent a of Ti may be 5%≤a≤40%, 10%≤a≤38%, 15%≤a≤30%, 20%≤a≤35%, or the like. More specifically, in an example, a may be specifically 5%. In an example, a may be specifically 8%. In an example, a may be specifically 10%. In an example, a may be specifically 13%. In an example, a may be specifically 15%. In an example, a may be specifically 18%. In an example, a may be specifically 20%. In an example, a may be specifically 25%. In an example, a may be specifically 28%. In an example, a may be specifically 30%. In an example, a may be specifically 32%. In an example, a may be specifically 35%. In an example, a may be specifically 37%. In an example, a may be specifically 40%. In an example, a may be specifically 45%.

When the value range of the atom percent a of Ti is 20%≤a≤35%, the phase-change memory material has better performance in the operation delay, power consumption, thermal stability, the fatigue life, and the like.

In a possible implementation, a ratio of the atom percent b of Sb to the atom percent c of Te may be 0.5≤(b:c)≤1, 0.5≤(b:c)≤2, 1≤(b:c)≤3, 2≤(b:c)≤3, or the like. More specifically, in an example, (b:c) may be specifically 0.5, (2:3), 1, 2, 3, or the like.

When (b:c) is (2:3), the phase-change memory material has better performance in the operation delay, the power consumption, thermal stability, the fatigue life, and the like.

In a possible implementation, the value range of the atom percent a of Ti is 20%≤a≤35%, and the ratio of the atom percent b of Sb to the atom percent c of Te is 2:3.

In this implementation, the phase-change memory material has a lower operation delay, lower power consumption, higher thermal stability, and a higher fatigue life.

In a possible implementation, the atom percent d of the doping element D may be 0%≤d≤10%, 0%≤d≤8%, 3%≤d≤10%, or 3%≤d≤8%. More specifically, in an example, the atom percent d of the doping element D is 0, that is, the phase-change memory material does not include the doping element D. In an example, d is 1%. In an example, d is 3%. In an example, d is 5%. In an example, d is 8%. In an example, d is 10%. In an example, d is 15%.

When 3%<_d<_8%, the phase-change memory material has a lower operation delay and a higher fatigue life.

In a possible implementation, the doping element includes one or a combination of at least two of a first non-metallic element, a first metallic element, and a telluride of the first metallic element, where the first non-metallic element is one or a combination of at least two of C, O, N, and Si; and the first metallic element is one or a combination of at least two of Zr, Cr, Al, Sc, Y, Ta, Hf, Er, In, Ge, Ga, and Sn.

In this implementation, the doping element is doped into the phase-change memory material, so that a thermal stability and the fatigue life of the phase-change memory material can be improved, and a crystallization speed (to be specific, a speed of the conversion from the high resistance state to the low resistance state) of the phase-change memory material can be further increased. Therefore, the operation delay is reduced.

According to a second aspect, a preparation method of a phase-change memory material is provided, where the method may be used to prepare the phase-change memory material provided in the first aspect. The method includes: preparing the phase-change memory material in a first deposition manner according to an element proportion shown by a formula (1), where the first deposition manner belongs to one of chemical vapor deposition CVD, physical vapor deposition PVD, and atomic layer deposition ALD.

TiₐSb_{b}Te_{c}D_{d} (1).

a represents an atom percent of Ti, b represents an atom percent of Sb, c represents an atom percent of Te, d represents an atom percent of an element D, and a+b+c+d=1; 3%≤a≤45%, and 0.5≤(b:c)≤3; and D is a doping element, and 0≤d≤15%.

The method can efficiently prepare the phase-change memory material, is easy to operate, and is easy to implement industrially.

In a possible implementation, the first deposition manner is a sputtering manner in the physical vapor deposition, and the preparing the phase-change memory material in a first deposition manner according to an element proportion shown by a formula (1) includes: preparing a first target material according to atom percents shown by the formula (1); and performing sputtering on the first target material to obtain the phase-change memory material.

In this implementation, an alloy target material may be first prepared, and then the sputtering is performed on the alloy target material to obtain the phase-change memory material. The manner is simpler and easier to implement, saves preparation time, and is easy to implement industrially.

In a possible implementation, the first deposition manner is a sputtering manner in the physical vapor deposition, and the preparing the phase-change memory material in a first deposition manner according to an element proportion shown by a formula (1) includes: performing co-sputtering on a Ti single elemental target material and an SbTe alloy target material to obtain the phase-change memory material, where sputtering power of different single elemental target materials is adjusted in a co-sputtering process according to the atom percents shown by the formula (1).

In this implementation, the co-sputtering may be performed on the single elemental target material and the alloy target material to obtain the phase-change memory material. The manner is simple and easy to implement, saves the preparation time, and is easy to implement industrially.

According to a third aspect, a phase-change memory chip is provided, including a plurality of memory cells, where the plurality of memory cells form a memory cell array, and each memory cell includes: a phase-change layer, an electrode located on one side of the phase-change layer, and an electrode located on another side of the phase-change layer, where the phase-change layer is made of the phase-change memory material provided in the first aspect.

The phase-change memory chip has advantages of a low operation delay, low power consumption, high thermal stability, and a high fatigue life.

In a possible implementation, each memory cell further includes a buffer layer in contact with the phase-change layer, where the buffer layer is made of one of carbon, a third metal, a nitride of the third metal, and a telluride of the fourth metal; and the third metal is one or a combination of at least two of W, Ta, and Ti, and the fourth metal is one or a combination of at least two of Zr, Cr, Al, Sc, Y, Ta, Hf, Er, In, Ge, Bi, Ti, Ga, and Sn.

In this implementation, the buffer layer in contact with the phase-change layer is introduced, so that performance of the phase-change layer and the memory chip can be further improved. Specifically, when a material of the buffer layer is carbon, the buffer layer can improve a heat insulation effect of the phase-change layer, reduce operation power consumption of the phase-change memory chip, avoid element diffusion in the phase-change layer, and improve an adhesion effect between the phase-change layer and the electrode. When the material of the buffer layer is the telluride of the fourth metal such as Zr, Cr, Al, Sc, Y, Ta, Hf, Er, In, Ge, Bi, Ti, Ga, or Sn, the buffer layer may be used as a crystallization template of the phase-change memory material, so that a speed of conversion of the phase-change memory material from an amorphous state to a crystalline state can be accelerated. Therefore, an operation delay of the phase-change memory chip can be reduced, heating efficiency of the phase-change memory chip can be improved, and the operation power consumption of the phase-change memory chip can be reduced. When the material of the buffer layer is the third metal such as W, Ta, or Ti, the buffer layer can avoid the element diffusion in the phase-change memory material, and can also improve the adhesion effect between the phase-change layer and the electrode. When the material of the buffer layer is the nitride of the third metal, the buffer layer can improve the adhesion effect between the phase-change layer and the electrode, improve heating efficiency of the phase-change memory material, reduce resistance drift, repair a void at an interface of the phase-change memory material, improve the adhesion effect between the phase-change layer and the electrode, and so on.

In a possible implementation, the buffer layer is located between the phase-change layer and the electrode; the buffer layer is located between the phase-change layer and the electrode; the phase-change layer has a groove, and the buffer layer is located in the groove of the phase-change layer; or the buffer layer has a groove, and the phase-change layer is located in the groove of the buffer layer.

In this implementation, the phase-change layer and the buffer layer may be in contact in a plurality of manners, so that the phase-change memory chip can be flexibly implemented and is easy to prepare.

In a possible implementation, each memory cell further includes at least one phase-change layer and at least one chalcogenide layer. Both the at least one phase-change layer and the at least one chalcogenide layer are located between a first electrode and a second electrode, and the at least one phase-change layer and the at least one chalcogenide layer are stacked alternately.

In this implementation, the phase-change layer and the chalcogenide layer are stacked alternately, so that more interfaces can be introduced to the phase-change memory material in the phase-change memory chip, and the interfaces can reduce thermal conduction. Therefore, the operation power consumption of the phase-change memory chip is reduced, and a fatigue life of the phase-change memory chip is improved. In addition, a chalcogenide has good thermal insulation performance. This can reduce the operation power consumption of the phase-change memory chip and improve the fatigue life of the phase-change memory chip.

In a possible implementation, a lattice coefficient of the chalcogenide layer is less than a lattice coefficient of SbTe.

In this implementation, a material whose lattice coefficient is less than the lattice coefficient of SbTe, such as TiTe₂, may be used as a material of the chalcogenide layer 115. This can avoid element diffusion of the phase-change layer, and improve a fatigue life of the phase-change layer, in other words, improve the fatigue life the phase-change memory chip.

According to a fourth aspect, a storage device is provided, where the storage device includes a controller and the phase-change memory chip provided in the third aspect, the phase-change memory chip is configured to store data, and the controller is configured to write data into the memory chip or read data from the memory chip.

According to a fifth aspect, an electronic device is provided, including a processor and the storage device provided in the fourth aspect, where the storage device is configured to store data, and the processor is configured to write data into the storage device or read data from the storage device.

The phase-change memory material and the phase-change memory chip provided in embodiments of this application have a low operation delay. When the phase-change memory material and the phase-change memory chip are used in a storage-class memory, the storage-class memory has a low delay, so that operation delays of a storage device and an electronic device in which the phase-change memory material and the phase-change memory chip are located can be further reduced. In addition, the phase-change memory material and the phase-change memory chip further have low operation power consumption, so that power consumption of the storage device and the electronic device in which the phase-change memory material and the phase-change memory chip are located can be reduced. Further, the phase-change memory material and the phase-change memory chip have a high fatigue life, so that a service life of the storage device and the electronic device in which the phase-change memory material and the phase-change memory chip are located can be improved.

### BRIEF DESCRIPTION OF DRAWINGS

FIG. 1A is a diagram of a structure of a phase-change memory cell according to an embodiment of this application;
FIG. 1B is a diagram of a structure of another phase-change memory cell according to an embodiment of this application;
FIG. 2 is a diagram of a structure of a phase-change memory cell array according to an embodiment of this application;
FIG. 3A is a diagram of a low resistance state of a germanium-antimony-tellurium system phase-change memory material;
FIG. 3B is a diagram of a high resistance state of a germanium-antimony-tellurium system phase-change memory material;
FIG. 4A is a diagram of a low resistance state of a phase-change memory material according to an embodiment of this application;
FIG. 4B is a diagram of a high resistance state of a phase-change memory material according to an embodiment of this application;
FIG. 5A is a display diagram of a grain size of a phase-change memory material according to an embodiment of this application;
FIG. 5B is a display diagram of a grain size of a phase-change memory material according to an embodiment of this application;
FIG. 6 is a display diagram of a resistance-temperature curve of a phase-change memory material according to an embodiment of this application;
FIG. 7A is a diagram of a structure of a phase-change memory cell array according to an embodiment of this application;
FIG. 7B is a diagram of a structure of a phase-change memory cell array according to an embodiment of this application;
FIG. 7C is a diagram of a structure of a phase-change memory cell array according to an embodiment of this application;
FIG. 7D is a diagram of a structure of a phase-change memory cell array according to an embodiment of this application;
FIG. 7E is a diagram of a structure of a phase-change memory cell array according to an embodiment of this application;
FIG. 8A is a diagram of a structure of a phase-change memory cell array according to an embodiment of this application;
FIG. 8B is a diagram of a structure of a phase-change memory cell array according to an embodiment of this application;
FIG. 8C is a diagram of a structure of a phase-change memory cell array according to an embodiment of this application;
FIG. 8D is a diagram of a structure of a phase-change memory cell array according to an embodiment of this application;
FIG. 9 is a diagram of a structure of a storage device according to an embodiment of this application; and
FIG. 10 is a diagram of a structure of an electronic device according to an embodiment of this application.

### DESCRIPTION OF EMBODIMENTS

The following describes technical solutions in embodiments of this application with reference to the accompanying drawings. It is clear that the described embodiments are merely a part of but not all of embodiments of this application.

In the descriptions of this specification, specific features, structures, materials, or characteristics may be combined in a proper manner in any one or more embodiments or examples.

It may be understood that in the descriptions of embodiments of this application, a word such as "example", "for example", or "exemplary" is used to represent giving an example, an illustration, or a description. Any embodiment or design scheme described as an "example", "for example", or "exemplary" in embodiments of this application should not be explained as being more preferred or having more advantages than another embodiment or design scheme. Exactly, use of the word such as "example", "for example", or "exemplary" is intended to present a related concept in a specific manner.

A term "and/or" in the descriptions of embodiments of this application describes only an association relationship between associated objects and indicates that there may be three relationships. For example, A and/or B may indicate the following three cases: Only A exists, only B exists, and both A and B exist. In addition, unless otherwise stated, a term "a plurality of" means two or more than two. For example, a plurality of systems mean two or more systems, and a plurality of terminals mean two or more terminals.

A phase-change memory chip is a chip that stores data by using a conductivity difference shown by a phase-change memory material during conversion of the phase-change memory material between a crystalline state and an amorphous state. Specifically, in the crystalline state, atoms in the phase-change memory material are arranged in order, so that the phase-change memory material has a long-distance atomic energy level and high free electron density, and therefore, the phase-change memory material has low resistivity. Therefore, the crystalline state may be referred to as a low resistance state. In the amorphous state, the atoms in the phase-change memory material are arranged in a disorderly manner, so that the phase-change memory material has a short-distance atomic energy level and low free electron density, and therefore, the phase-change memory material has high resistivity. Therefore, the amorphous state may be referred to as a high resistance state. It may be set that a phase-change memory material in the low resistance state corresponds to one of "0" and " 1", and a phase-change memory material in the high resistance state corresponds to the other of "0" and "1".

When a specific pulse voltage is applied to the phase-change memory material, the phase-change memory material may be converted between the high resistance state and the low resistance state. Specifically, a high and narrow electrical pulse (which may be referred to as a reset pulse) may be applied to the phase-change memory chip, so that the phase-change memory material is converted from the low resistance state to the high resistance state. A low and wide electrical pulse (which may be referred to as a set pulse) may be applied to the phase-change memory chip, so that the phase-change memory material is converted from the high resistance state to the low resistance state. Therefore, a write operation on the phase-change memory material can be implemented.

In addition, the high resistance state and the low resistance state of the phase-change memory material respectively correspond to different bit values. In this way, a low read voltage (a voltage that cannot cause the phase-change memory material to be converted between the high resistance state and the low resistance state) may be applied to the phase-change memory material, to read a resistance value of the phase-change memory material, and implement a read operation.

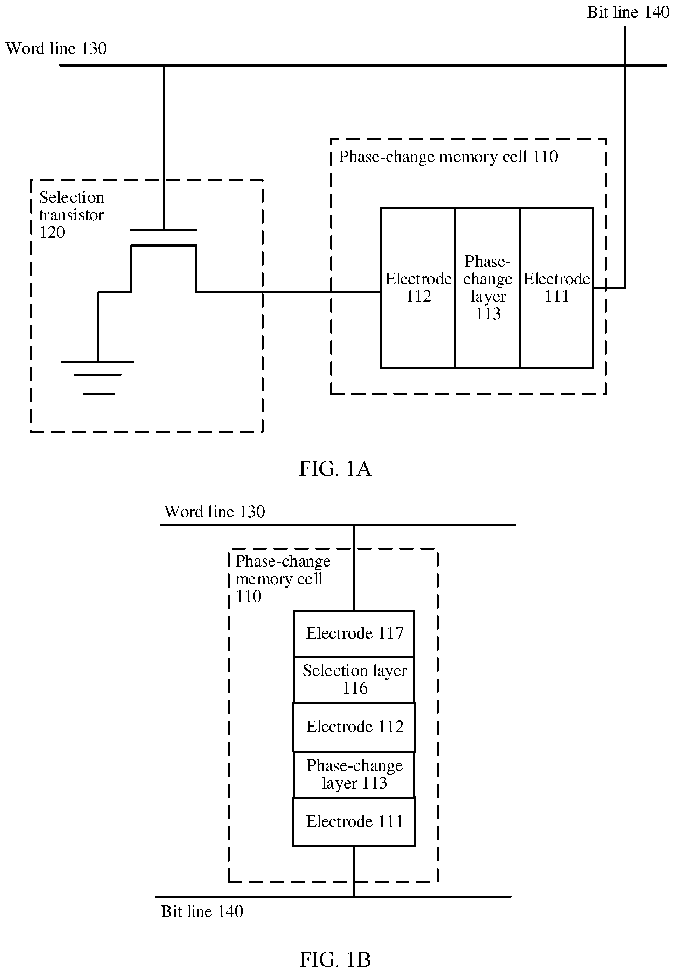

FIG. 1A shows an implementation of a phase-change memory cell 110 and a corresponding selector 120. The phase-change memory cell is a memory cell that is in a phase-change memory chip and that is configured to store one bit value ("0" or "1"). As shown in FIG. 1A, the phase-change memory cell 110 may include an electrode 111, an electrode 112, and a phase-change layer 113 located between the electrode 111 and the electrode 112. The phase-change layer 113 is made of a phase-change memory material. A voltage or a current is applied to the phase-change layer 113 through the electrode 111 and the electrode 112, to implement a write operation or a read operation.

During writing, a current or a voltage is applied to a word line 130, so that the word line 130 is at a high potential, and the transistor 120 is conducted. Then, a current or a voltage is applied to a bit line 140, so that the phase-change layer of the phase-change memory cell is converted between a high resistance state and a low resistance state, to perform the write operation. During reading, a column selection circuit adds a small preset potential to the bit line 140 (where the preset potential does not change a resistance state of the phase-change memory cell). As described above, the word line 130 is at the high potential. This affects a potential on the bit line 140, where a magnitude of influence is related to a magnitude of a resistance of the phase-change memory cell. The influence of the word line 130 on the potential on the bit line 140 is equivalent to that the phase-change memory cell outputs a signal, and an influence result (a potential on the bit line 140 after being affected by the word line 130) is equivalent to the output signal. The influence result is compared with a reference potential, to determine a resistance state of the phase-change memory cell, and determine, based on the resistance state, data stored in the phase-change memory cell. The column selection circuit is described below, and details are not described herein.

FIG. 1B shows another implementation of a phase-change memory cell 110. The phase-change memory cell 110 may include an electrode 111, a phase-change layer 113, an electrode 112, a selection layer 116 (which may also be referred to as a selection tube 116), and an electrode 117 that are sequentially adjacent to each other. The phase-change layer 113 may include a phase-change memory material. A voltage or a current may be applied to the phase-change layer 113 between the electrode 111 and the electrode 112, to implement a write operation or a read operation.

Specifically, the electrode 112 may be connected to a word line 130 through the selection layer 116 and the electrode 117. When a voltage difference between two ends of the selection layer 116 exceeds a threshold switching voltage Vₜₕ of the selection layer 116, the selection layer 116 is conducted, and voltages at the two ends of the selection layer 116 decrease, so that more voltages are applied to two ends of the phase-change layer 113. Therefore, the write operation or the read operation can be implemented.

In some embodiments, a material of the selection layer 116 is a threshold switching device (ovonic threshold switching, OTS) material including Ge, Se, and As. The OTS material forming the selection layer 116 may be doped with at least one of Si, N, and S. In some embodiments, the material of the selection layer 116 is a GeAsSe alloy. In some embodiments, the material of the selection layer 116 is a GeAsSe alloy doped with at least one of Si, N, C, As, Se, and the like.

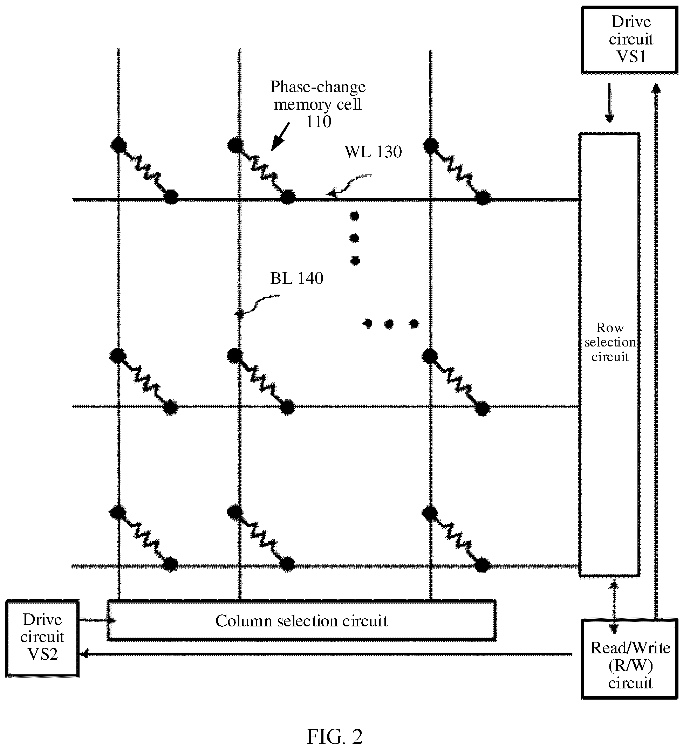

In addition, materials of the phase-change layer 113, the electrode 111, the electrode 112, the electrode 116, and the electrode 117 are described below. In the following descriptions, when no particular distinction is made, the electrode 111, the electrode 112, the electrode 116, and the electrode 117 may be referred to as electrodes for short. FIG. 2 shows a phase-change memory chip, including a phase-change memory cell array and a peripheral circuit. The phase-change memory cell array includes a plurality of phase-change memory cells arranged in a crosswise manner, to form a high-density memory array. A phase-change memory cell 110 may be one phase-change memory cell in the phase-change memory cell array. The phase-change memory cell 110 may use the structure shown in FIG. 1A, or may use the structure shown in FIG. 1B. In addition, when the phase-change memory cell in the phase-change memory cell array is specifically of the structure shown in FIG. 1A, the phase-change memory cell array further includes a selection transistor (not shown in FIG. 2) of the phase-change memory cell. For the phase-change memory cell, when a bit line and a word line are selected at the same time, and a selector is in a conducted state, the phase-change memory cell is in a selected state; otherwise, the phase-change memory cell is in an unselected state. A processor (not shown) may select a word line 130 through a row selection circuit, select a bit line 140 through a column selection circuit, and control a selection transistor 120 to be conducted, to select the phase-change memory cell 110. A read/write (R/W) circuit may receive a command of the processor, control the row selection circuit and the column selection circuit based on the command, and apply a voltage to the phase-change memory cell 110 through the word line 130 and the bit line 140, to perform a read operation or a write operation. A drive circuit VS1 may apply, under control of the row selection circuit, a voltage to the phase-change memory cell 110 through the word line 130, and a drive circuit VS2 may apply, under control of the column selection circuit, a voltage to the phase-change memory cell 110 through the bit line 140.

The foregoing examples describe structures of the phase-change memory chip and the phase-change memory cell provided in embodiments of this application. The following describes the phase-change memory material.

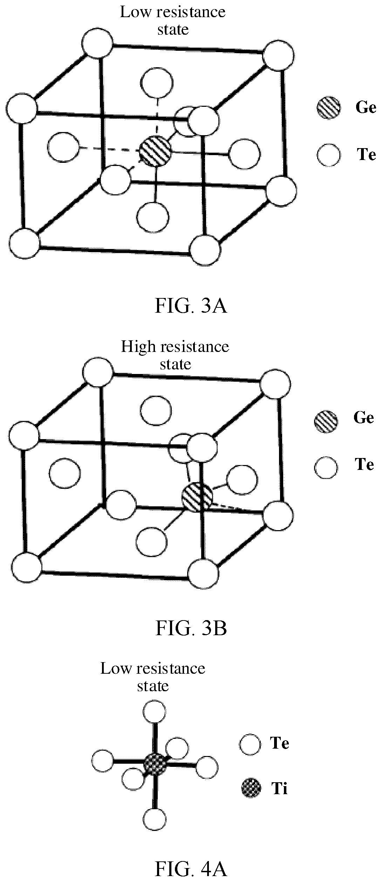

Performance in phase-change power consumption (to be specific, energy consumption required for conversion between a high resistance state and a low resistance state), a fatigue life, a phase-change speed (time required for the conversion between the high resistance state and the low resistance state), a thermal stability, and the like of the phase-change memory material has important influence on an operation delay, a life, and reliability of the phase-change memory chip. A conventional germanium-antimony-tellurium (GeSbTe, GST) system phase-change memory material has good thermal stability and a good fatigue life. However, as shown in FIG. 3A and FIG. 3B, the conversion between the high resistance state and the low resistance state involves breaking and recombination of a GeTe bond, which delays a phase-change process (to be specific, a speed of the conversion between the high resistance state and the low resistance state is slow). As a result, the operation delay is high (100 ns level). This cannot fully meet a requirement for a low delay of a storage-class memory (storage-class memory, SCM). Therefore, even if the phase-change memory material is used in the storage-class memory, a delay of the storage-class memory is high.

An embodiment of this application provides a Ti doped SbTe phase-change memory material. Ti doping improves thermal stability of an SbTe phase-change system, reduces phase-change power consumption, and improves a fatigue life. In addition, existence of a TiTe nucleation center can accelerate crystallization, and therefore, reduce an operation delay. A chemical general formula of the Ti doped SbTe phase-change memory material is: TiₐSb_{b}Te_{c}D_{d}. a represents an atom percent of a chemical element titanium Ti. To be specific, a represents a proportion of the chemical element titanium Ti in a total quantity of all atoms in the phase-change memory material. b represents an atom percent of a chemical element antimony Sb. To be specific, b represents a proportion of the chemical element antimony Sb in the total quantity of all atoms in the phase-change memory material. c represents an atom percent of a chemical element tellurium Te. To be specific, c represents a proportion of the chemical element tellurium Te in the total quantity of all atoms in the phase-change memory material. d represents an atom percent of a doping element D. To be specific, d represents a proportion of the doping element D in the total quantity of all atoms in the phase-change memory material. In short, a+b+c+d=1.

In the phase-change memory material provided in this embodiment of this application, 3%≤a≤45%. To be specific, the proportion of Ti in the total quantity of all atoms in the phase-change memory material is greater than or equal to 3% and is less than or equal to 45%. In addition, 0.5≤(b:c)≤3. To be specific, in the phase-change memory material, a ratio of an atom quantity of Sb to an atom quantity of Te is greater than or equal to 0.5 and less than or equal to 3. 0≤d≤15%. To be specific, the proportion of the doping element D in the total quantity of all atoms in the phase-change memory material is less than or equal to 15%. In other words, the phase-change memory material may not include the doping element, or may include the doping element, and the atom percentage of the doping element does not exceed 15%.

The phase-change memory material provided in this embodiment of this application is a new Sb-Te-based phase-change memory material. When SbTe is crystallized, that is, in a crystalline state, the phase-change memory material is in the low resistance state; or when SbTe is amorphous, that is, in an amorphous state, the phase-change memory material is in the high resistance state. Different resistance states of the phase-change memory material may represent different information, to implement information storage. In addition, the information can be read by measuring the resistance state of the phase-change memory material.

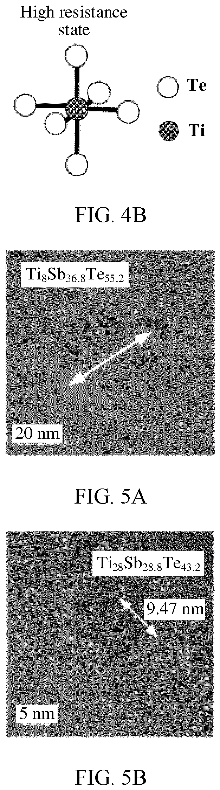

Refer to FIG. 4A and FIG. 4B. In a phase-change memory material provided in an embodiment of this application, Ti and Te form a TiTe nucleation center, and TiTe has stronger bonding strength than SbTe. When SbTe is converted from a crystalline state (that is, a low resistance state) to an amorphous state (that is, a high resistance state), the TiTe nucleation center can maintain a stable structure. Therefore, the TiTe nucleation center exists in both the low resistance state and the high resistance state of the phase-change memory material. When the phase-change memory material is converted from the high resistance state (that is, the amorphous state) to the low resistance state (that is, the crystalline state), the TiTe nucleation center, as a nucleation center for recrystallization, can increase a crystallization speed of SbTe, so that an operation delay is reduced. Crystallization is a process in which an atomic structure in a material is changed from disorder to orderly arrangement, that is, a process of converting the amorphous state to the crystalline state.

In addition, a lattice mismatch degree between lattices of TiTe and SbTe is 12%, and Ti is introduced into the phase-change memory material provided in this embodiment of this application. This may cause lattice distortion or a lattice defect of TiSbTe, so that the phase-change memory material is converted from the crystalline state to the amorphous state more easily, and therefore, power consumption required for conversion from the crystalline state to the amorphous state can be reduced.

In addition, based on an experimental test, Ti included in the phase-change memory material provided in this embodiment of this application can reduce a grain size, and therefore, improve a fatigue life.

In addition, based on the experimental test, Ti included in the phase-change memory material provided in this embodiment of this application can improve thermal stability of the phase-change memory material in the low resistance state and the high resistance state.

In some embodiments, a value range of an atom percent a of Ti may be 5%≤a≤40%, 10%≤a≤38%, 15%≤a≤30%, 20%≤a≤35%, or the like. Details are not listed one by one herein. When the value range of the atom percent a of Ti is 20%≤a≤35%, the phase-change memory material has better performance in the operation delay, the power consumption, the thermal stability, the fatigue life, and the like.

In an example, a may be specifically 5%. In an example, a may be specifically 8%. In an example, a may be specifically 10%. In an example, a may be specifically 13%. In an example, a may be specifically 15%. In an example, a may be specifically 18%. In an example, a may be specifically 20%. In an example, a may be specifically 25%. In an example, a may be specifically 28%. In an example, a may be specifically 30%. In an example, a may be specifically 32%. In an example, a may be specifically 35%. In an example, a may be specifically 37%. In an example, a may be specifically 40%. In an example, a may be specifically 45%.

In some embodiments, a ratio of an atom percent b of Sb to an atom percent c of Te, that is, (b:c), may be 0.5≤(b:c)≤1, 0.5≤(b:c)≤2, 1≤(b:c)≤3, 2≤(b:c)≤3, or the like. Details are not listed one by one herein.

In an example, (b:c) may be specifically 0.5, (2:3), 1, 2, 3, or the like. Details are not listed one by one herein. When (b:c) is (2:3), the phase-change memory material has better performance in the operation delay, the power consumption, thermal stability, the fatigue life, and the like.

In some embodiments, the value range of the atom percent a of Ti is 20%≤a≤35%, and the ratio of the atom percent b of Sb to the atom percent c of Te is (2:3). In this case, the phase-change memory material has a lower operation delay, lower power consumption, higher thermal stability, and a higher fatigue life.

In some embodiments, a doping element D may be specifically one or a combination of at least two of non-metallic elements such as C, O, N, and Si. In some embodiments, the doping element D may be specifically one or a combination of at least two of metallic elements such as Zr, Cr, Al, Sc, Y, Ta, Hf, Er, In, Ge, Ga, and Sn. In some embodiments, the doping element D may be specifically one or a combination of at least two of tellurides of the metallic elements such as Zr, Cr, Al, Sc, Y, Ta, Hf, Er, In, Ge, Ga, and Sn. In some embodiments, the doping element D may be specifically one or a combination of at least two of the non-metallic elements such as C, O, N, and Si, the metallic elements such as Zr, Cr, Al, Sc, Y, Ta, Hf, Er, In, Ge, Ga, and Sn, and the tellurides of the metallic elements.

The doping element D is added into the phase-change memory material, so that a thermal stability and the fatigue life of the phase-change memory material can be improved, and a crystallization speed (to be specific, a speed of conversion from the high resistance state to the low resistance state) of the phase-change memory material can be further increased. Therefore, the operation delay is reduced.

In some embodiments, an atom percent d of the doping element D may be 0%≤d≤10%, 0%≤d≤8%, 3%≤d≤10%, or 3%≤d≤8%. When 3%≤d≤8%, the phase-change memory material has a lower operation delay and a higher fatigue life.

In an example, the atom percent d of the doping element D is 0, that is, the phase-change memory material does not include the doping element D. In an example, d is 1%. In an example, d is 3%. In an example, d is 5%. In an example, d is 8%. In an example, d is 10%. In an example, d is 15%.

The foregoing examples describe compositions of the phase-change memory material. The following uses examples to describe preparation solutions of the phase-change memory material.

In embodiments of this application, the phase-change memory material may be deposited on a base material according to an element ratio shown by TiₐSb_{b}Te_{c}D_{d} in a material deposition manner such as chemical vapor deposition (chemical vapor deposition, CVD), physical vapor deposition (physical vapor deposition, PVD), or atomic layer deposition (atomic layer deposition, ALD). The base material may be an electrode, may be an electrode, may be a buffer layer to be described below, may be a chalcogenide layer to be described below, or may be another specific base material. Details are not described herein.

In some embodiments, the phase-change memory material is prepared on the base material by using a Ti single elemental target material and an SbTe alloy target material. In a sputtering process, different deposition rates may be obtained by controlling power of different target materials, to obtain a phase-change memory material with a corresponding composition distribution ratio.

In some embodiments, the phase-change memory material may be specifically prepared on the base material by sputtering a single-target material in a sputtering manner (for example, a magnetron sputtering method) in the physical vapor deposition. Specifically, when a doping element D is not included, or a doping element D1 is not N and/or O, sputtering may be performed using a Ti single elemental target material, an Sb single elemental target material, a Te single elemental target material, and a doping element D (when a phase-change material includes the doping element D) single elemental target material, to prepare the phase-change memory material on the base material. When the doping element D1 is N, sputtering may be performed using a titanium nitride alloy target material, an Sb single elemental target material, and a Te single elemental target material, to prepare the phase-change memory material on the base material. When the doping element D1 is O, sputtering may be performed using a titanium oxide alloy target material, an Sb single elemental target material, and a Te single elemental target material, to prepare the phase-change memory material on the base material. In the sputtering process, different deposition rates may be obtained by controlling the power of the different target materials, to obtain the phase-change memory material with the corresponding composition distribution ratio.

In some embodiments, a TiₐSb_{b}Te_{c}D_{d} alloy may be prepared (for example, smelted) first. Then, the sputtering is performed using the TiₐSb_{b}Te_{c}D_{d} alloy, to prepare the phase-change memory material on the base material.

The following describes a preparation process of the phase-change memory material in specific embodiments.

### Embodiment 1

A phase-change memory material whose element composition is Ti₈Sb_{36.8}Te_{55.2} is prepared. Details are as follows.

A Ti single elemental target material and an SbTe alloy target material each having an atom percentage purity of not less than 99.99% are placed at different target material locations in a sputtering cavity. A ratio of atoms of Sb to atoms of Te in the SbTe alloy is 2:3. A base material is placed on a sample table in the sputtering cavity. Sputtering power is applied to the Ti single elemental target material and the SbTe alloy target material to generate sputtering glow. Sputtering power applied to the Ti single elemental target material is 10W, and sputtering power applied to the SbTe alloy target material is 7W. An argon flow is 35 sccm in a sputtering process. In this way, the phase-change memory material whose element composition is Ti₈Sb_{36.8}Te_{55.2} can be prepared on the base material.

### Embodiment 2

A phase-change memory material whose element composition is Ti₂₂Sb_{31.2}Te_{46.8} is prepared. Details are as follows.

A Ti single elemental target material and an SbTe alloy target material each having an atom percentage purity of not less than 99.99% are placed at different target material locations in a sputtering cavity. A ratio of atoms of Sb to atoms of Te in the SbTe alloy is 2:3. A base material is placed on a sample table in the sputtering cavity. Sputtering power is applied to the Ti single elemental target material and the SbTe alloy target material to generate sputtering glow. Sputtering power applied to the Ti single elemental target material is 30W, and sputtering power applied to the SbTe alloy target material is 7W. An argon flow is 35 sccm in a sputtering process. In this way, the phase-change memory material whose element composition is Ti₂₂Sb_{31.2}Te_{46.8} can be prepared on the base material.

### Embodiment 3

A phase-change memory material whose element composition is Ti₂₈Sb_{28.8}Te_{43.2} is prepared. Details are as follows.

A Ti single elemental target material and an SbTe alloy target material each having an atom percentage purity of not less than 99.99% are placed at different target material locations in a sputtering cavity. A ratio of atoms of Sb to atoms of Te in the SbTe alloy is 2:3. A base material is placed on a sample table in the sputtering cavity. Sputtering power is applied to the Ti single elemental target material and the SbTe alloy target material to generate sputtering glow. Sputtering power applied to the Ti single elemental target material is 40W, and sputtering power applied to the SbTe alloy target material is 7W. An argon flow is 35 sccm in a sputtering process. In this way, the phase-change memory material whose element composition is Ti₂₂Sb_{31.2}Te_{46.8} can be prepared on the base material.

### Embodiment 4

A phase-change memory material whose element composition is Ti₃Sb_{38.8}Te_{58.2} is prepared. For a specific preparation process, refer to the descriptions in Embodiment 1. Details are not described herein again.

### Embodiment 5

A phase-change memory material whose element composition is Ti₄₅Sb_{18.8}Te_{36.2} is prepared. For a specific preparation process, refer to the descriptions in Embodiment 1. Details are not described herein again.

### Embodiment 6

A phase-change memory material whose element composition is Ti₄₀Sb_{23.8}Te_{36.2} is prepared. For a specific preparation process, refer to the descriptions in Embodiment 1. Details are not described herein again.

### Embodiment 7

A phase-change memory material whose element composition is Ti₂₁Sb_{29.6}Te_{44.4}C₅ is prepared. An alloy whose element composition is Ti₂₁Sb_{29.6}Te_{44.4}C₅ is smelted. The Ti₂₁Sb_{29.6}Te_{44.4}C₅ alloy is placed at a target material location in a sputtering cavity. A base material is placed on a sample table in the sputtering cavity. Sputtering power is applied to the Ti₂₁Sb_{29.6}Te_{44.4}C₅ alloy to generate sputtering glow. Therefore, the Ti₂₁Sb_{29.6}Te_{44.4}C₅ alloy is sputtered onto the base material, to prepare the Ti₂₁Sb_{29.6}Te_{44.4}C₅ phase-change memory material.

### Embodiment 8

A phase-change memory material whose element composition is Ti_{25.7}Sb_{27.7}Te_{41.6}C₅ is prepared. An alloy whose element composition is Ti_{25.7}Sb_{27.7}Te_{41.6}C₅ is smelted. The Ti_{25.7}Sb_{27.7}Te_{41.6}C₅ alloy is placed at a target material location in a sputtering cavity. Abase material is placed on a sample table in the sputtering cavity. Sputtering power is applied to the Ti_{25.7}Sb_{27.7}Te_{41.6}C₅ alloy to generate sputtering glow. Therefore, the Ti_{25.7}Sb_{27.7}Te_{41.6}C₅ alloy is sputtered onto the base material, to prepare the Ti_{25.7}Sb_{27.7}Te_{41.6}C₅ phase-change memory material.

### Embodiment 9

A phase-change memory material whose element composition is Ti₁₇Sb_{31.2}Te_{46.8}O₅ is prepared. An alloy whose element composition is Ti₁₇Sb_{31.2}Te_{46.8}O₅ is smelted. The Ti₁₇Sb_{31.2}Te_{46.8}O₅ alloy is placed at a target material location in a sputtering cavity. A base material is placed on a sample table in the sputtering cavity. Sputtering power is applied to the Ti₁₇Sb_{31.2}Te_{46.8}O₅ alloy to generate sputtering glow. Therefore, the Ti₁₇Sb_{31.2}Te_{46.8}O₅ alloy is sputtered onto the base material, to prepare the Ti₁₇Sb_{31.2}Te_{46.8}O₅ phase-change memory material.

### Embodiment 10

A phase-change memory material whose element composition is Ti₁₄Sb_{31.2}Te_{46.8}Si₈ is prepared. An alloy whose element composition is Ti₁₄Sb_{31.2}Te_{46.8}Si₈ is smelted. The Ti₁₄Sb_{31.2}Te_{46.8}Si₈ alloy is placed at a target material location in a sputtering cavity. A base material is placed on a sample table in the sputtering cavity. Sputtering power is applied to the Ti₁₄Sb_{31.2}Te_{46.8}Si₈ alloy to generate sputtering glow. Therefore, the Ti₁₄Sb_{31.2}Te_{46.8}Si₈ alloy is sputtered onto the base material, to prepare the Ti₁₄Sb_{31.2}Te_{46.8}Si₈ phase-change memory material.

The foregoing examples describe the preparation solutions of the phase-change memory material provided in embodiments of this application. The following describes data related to a fatigue life and thermal stability of a phase-change memory material provided in embodiments of this application.

The phase-change memory material prepared in Embodiment 1 and the phase-change memory material prepared in Embodiment 2 are separately observed using a transmission electron microscope, and results are respectively shown in FIG. 5A and FIG. 5B. It can be seen that, when an atom percentage of Ti in the phase-change memory material is 8%, some grain sizes are tens of nanometers. When the atom percentage of Ti in the phase-change memory material increases to 28%, the grain size can be reduced to less than 10 nm. It indicates that Ti can reduce the grain size in the phase-change memory material, so that grain size distribution is more uniform (which may be understood that a smaller grain size indicates a smaller grain size distribution range, and the grain size distribution is more uniform). Therefore, a short fatigue life of the phase-change memory material caused by uneven grain sizes can be reduced or avoided. That is, when the atom percentage of Ti in the phase-change memory material is high (for example, 28%), the fatigue life of the phase-change memory material is high.

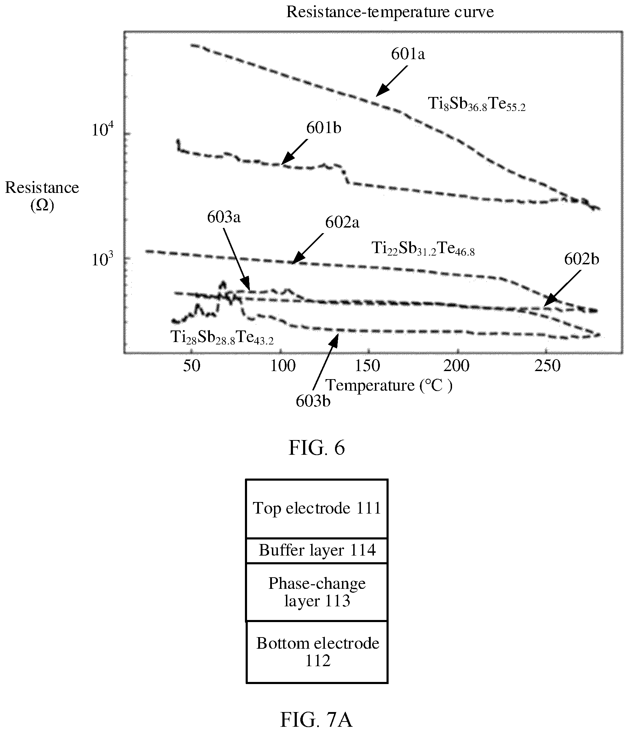

Resistances of the phase-change material prepared in Embodiment 1 are measured at different temperatures. Results are shown by a curve 601a and a curve 601b in FIG. 6. The curve 601a is a temperature rise curve, and the curve 601b is a temperature fall curve.

Resistances of the phase-change material prepared in Embodiment 2 are measured at different temperatures. Results are shown by a curve 602a and a curve 602b in FIG. 6. The curve 602a is a temperature rise curve, and the curve 602b is a temperature fall curve.

Resistances of the phase-change material prepared in Embodiment 3 are measured at different temperatures. Results are shown by a curve 603a and a curve 603b in FIG. 6. The curve 603a is a temperature rise curve, and the curve 603b is a temperature fall curve.

The temperature fall curve indicates a change of the resistance in a temperature falling process. The temperature rise curve indicates a change of the resistance in a temperature rising process. As shown in FIG. 6, in the temperature rising process of the phase-change memory material prepared in embodiments of this application, resistance decreasing indicates that the phase-change memory material is crystallizing. In the temperature falling process of the phase-change memory material, the basically unchanged resistance of the phase-change memory material indicates that crystallization is completed.

In addition, it can be seen from FIG. 6 that, as Ti concentration increases, an initial resistance of the phase-change memory material decreases, and a crystallization temperature increases. An abscissa of a location at which the resistance decreases fastest is the crystallization temperature. Specifically, a crystallization temperature of the phase-change material prepared in Embodiment 1 is about 210°C, a crystallization temperature of the phase-change material prepared in Embodiment 2 is about 240°C, and a crystallization temperature of the phase-change material prepared in Embodiment 3 is about 260°C. In addition, the initial resistance is a resistance corresponding to a minimum temperature on each curve in FIG. 6.

It can be learned from FIG. 6 that, in embodiments of this application, Ti is added to the phase-change memory material, so that the crystallization temperature of the phase-change memory material is increased. That is, the thermal stability of the phase-change memory material is improved.

The foregoing describes element compositions, preparation methods, and performance of the phase-change memory material provided in embodiments of this application. The following describes a phase-change memory chip formed by the phase-change memory material provided in embodiments of this application.

The phase-change memory chip provided in this embodiment of this application may include a phase-change memory cell memory array and a peripheral circuit. For details, refer to the foregoing descriptions of the embodiment shown in FIG. 2. Details are not described herein again.

The phase-change memory cell array may include a plurality of phase-change memory cells. In some embodiments, a structure of the phase-change memory cell may be implemented with reference to the structure shown in FIG. 1A. In some embodiments, a structure of the phase-change memory cell may be implemented with reference to the structure shown in FIG. 1B. Refer to FIG. 1A or FIG. 1B again. The phase-change layer 113 in the phase-change memory cell 110 may be the phase-change memory material provided in embodiments of this application. A material of an electrode may be a metallic material, a non-metallic material, a metallic nitride, or the like. More specifically, the material of an electrode 1 may be one or a combination of at least two of tungsten (W), carbon (C), tantalum Ta, titanium nitride (TiN), tantalum nitride (TaN), and the like. The material of the electrode is not specifically limited in this embodiment of this application.

In Embodiment a, the phase-change memory cell 110 may further include a buffer layer 114. The buffer layer 114 is in contact with the phase-change layer 113, and is also located between an electrode 111 and an electrode 112. In an illustrative example, a material of the buffer layer 114 may be a non-metal such as carbon (C). In an illustrative example, a material of the buffer layer 114 may be a non-metal such as carbon (C). In an illustrative example, a material of the buffer layer 114 may be a metal such as W, Ta, or Ti. In an illustrative example, a material of the buffer layer 114 may be a metallic nitride such as TiN or TaN. In an illustrative example, a material of the buffer layer 114 may be a telluride of a metal such as Zr, Cr, Al, Sc, Y, Ta, Hf, Er, In, Ge, Bi, Ti, Ga, or Sn.

The buffer layer 114 in contact with the phase-change layer 113 is introduced into the phase-change memory cell 110, so that performance of the phase-change layer 113 can be further improved. Specifically, when the material of the buffer layer 114 is the non-metal such as carbon (C), the buffer layer 114 can improve a heat insulation effect of the phase-change layer 113, reduce operation power consumption of the phase-change memory cell, avoid element diffusion in the phase-change layer 113, and improve an adhesion effect between the phase-change layer and the electrode. When the material of the buffer layer 114 is the telluride of the metal such as Zr, Cr, Al, Sc, Y, Ta, Hf, Er, In, Ge, Bi, Ti, Ga, or Sn, the buffer layer 114 may be used as a crystallization template of the phase-change memory material, so that a speed of conversion of the phase-change memory material from an amorphous state to a crystalline state can be accelerated. Therefore, an operation delay of the phase-change memory operation cell 110 can be reduced, heating efficiency of the phase-change memory cell 110 can be improved, and operation power consumption of the phase-change memory cell 110 can be reduced. When the material of the buffer layer 114 is the metal such as W or Ta, the buffer layer 114 can avoid element diffusion in the phase-change memory material, and can also improve an adhesion effect between the phase-change layer and the electrode. When the material of the buffer layer 114 is the metallic nitride, the buffer layer 114 can improve the adhesion effect between the phase-change layer and the electrode, improve heating efficiency of the phase-change memory material, reduce resistance drift, repair a void at an interface of the phase-change memory material, improve the adhesion effect between the phase-change layer and the electrode, and so on.

The foregoing describes the material and a function of the buffer layer 114. The following uses an example to describe a location relationship between the buffer layer 114 and the phase-change layer 113.

In an illustrative example of Embodiment a, with reference to FIG. 7A, the buffer layer 114 is in contact with the phase-change layer 113, and the buffer layer 114 is located between the phase-change layer 113 and the electrode 111.

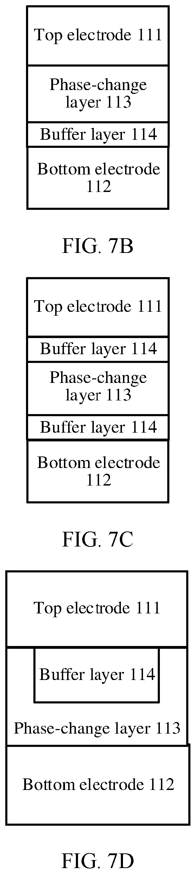

In another illustrative example of Embodiment a, with reference to FIG. 7B, the buffer layer 114 is in contact with the phase-change layer 113, and the buffer layer 114 is located between the phase-change layer 113 and the electrode 112.

In another illustrative example of Embodiment a, with reference to FIG. 7C, the phase-change memory cell 110 includes two buffer layers 114, and each buffer layer 114 is in contact with the phase-change layer 113. One buffer layer 114 is located between the phase-change layer 113 and the electrode 111, and the other buffer layer 114 is located between the phase-change layer 113 and the electrode 112. Materials of the two buffer layers 114 may be the same or may be different. For example, the materials of the two buffer layers 114 are both the non-metal such as carbon (C), the metal such as W or Ta, the metallic nitride such as TiN or TaN, or the telluride of the metal such as Zr, Cr, Al, Sc, Y, Ta, Hf, Er, In, Ge, Bi, Ti, Ga, or Sn. For example, a material of one of the two buffer layers 114 is the non-metal such as carbon (C), and a material of the other buffer layer 114 is the non-metal such as carbon (C); a material of one buffer layer 114 is the metallic nitride such as TiN or TaN, and a material of the other buffer layer 114 is the telluride of the metal such as Zr, Cr, Al, Sc, Y, Ta, Hf, Er, In, Ge, Bi, Ti, Ga, or Sn, or the like. Details are not listed one by one herein. The materials of the two buffer layers 114 are different, so that the phase-change memory cell 110 can have advantages corresponding to the two materials.

In another illustrative example of Embodiment a, with reference to FIG. 7D, the phase-change layer 113 has a groove, and the buffer layer 114 is located in the groove of the phase-change layer 113 and is in contact with the phase-change layer 113. That is, the phase-change layer 113 surrounds the buffer layer 114.

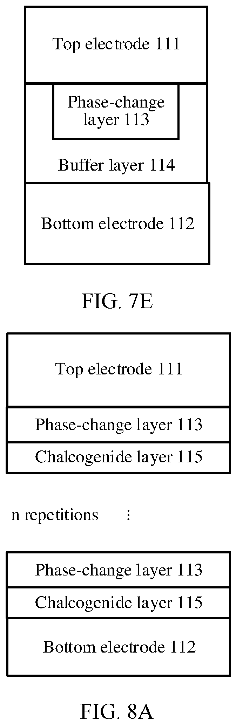

In another illustrative example of Embodiment a, with reference to FIG. 7E, the buffer layer 114 has a groove, and the phase-change layer 113 is located in the groove of the buffer layer 114 and is in contact with the buffer layer 114. That is, the buffer layer 114 surrounds the phase-change layer 113.

The foregoing uses the structures shown in FIG. 7A to FIG. 7E as examples to describe the location relationship between the phase-change layer 113 and the buffer layer 114, but the examples are not exhaustive. In another embodiment, the phase-change layer 113 and the buffer layer 114 may alternatively have another location relationship. Details are not listed one by one herein.

In Embodiment b, the phase-change memory cell 110 may further include at least one chalcogenide layer 115 and at least one phase-change layer 113. The at least one phase-change layer 113 and the at least one chalcogenide layer 115 are stacked alternately, and are both located between the electrode 111 and the electrode 112.

In an illustrative example of Embodiment b, a material of the chalcogenide layer 115 may be a metal sulfide, for example, GeSₓ.

In another illustrative example of Embodiment b, a material of the chalcogenide layer 115 may be a metal Te compound, for example, TiTe₂, HfₓTe_{y} or ZrₓTe_{y}.

In another illustrative example of Embodiment b, a material of the chalcogenide layer 115 may alternatively be a phase-change memory material, for example, one or a combination of at least two of SbₓTe_{y}, GeₓSb_{y}Te_{z}, GeₓTe_{y}, BiₓTe_{y}, and InₓTe_{y}. In the foregoing chemical formulas, subscripts x, y, and z respectively represent proportions of corresponding atoms.

The phase-change layer 113 and the chalcogenide layer 115 are stacked alternately. It is not difficult to understand that there is an interface between one phase-change layer 113 and one adjacent chalcogenide layer 115. In this way, alternate stacking of the phase-change layer 113 and the chalcogenide layer 115 can introduce more interfaces for the phase-change memory material, and the interface can reduce thermal conduction. Therefore, the operation power consumption of the phase-change memory cell 110 is reduced, and a fatigue life of the phase-change memory cell 110 is improved. In addition, a chalcogenide has good thermal insulation performance. This can reduce the operation power consumption of the phase-change memory cell 110 and improve the fatigue life of the phase-change memory cell 110. In addition, when the material of the chalcogenide layer 115 is TiTe₂ or the like, a lattice coefficient of the chalcogenide layer 115 is less than a lattice coefficient of the phase-change memory material provided in embodiments of this application, so that the element diffusion in the phase-change layer 113 can be avoided, and a fatigue life of the phase-change layer 113 is improved, in other words, the fatigue life of the phase-change memory cell 110 is improved.

In another illustrative example of Embodiment b, with reference to FIG. 8A, in a direction from the electrode 111 to the electrode 112, the at least one chalcogenide layer 115 and the at least one phase-change layer 113 are stacked alternately or arranged periodically, and n periodic repeated stacking may be formed starting from the phase-change layer 113 and ending at the chalcogenide layer 115. n is an integer greater than or equal to 1.

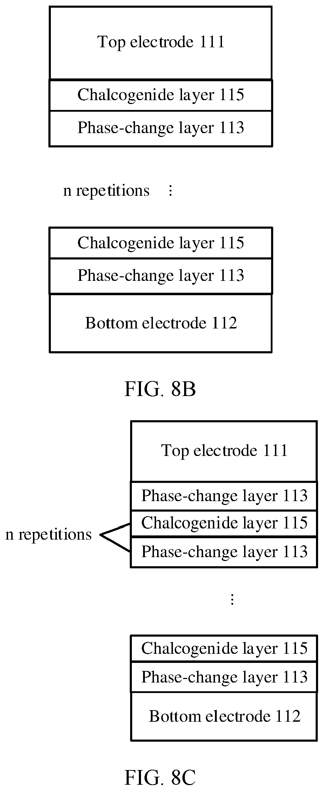

In another illustrative example of Embodiment b, with reference to FIG. 8B, in a direction from the electrode 111 to the electrode 112, the at least one chalcogenide layer 115 and the at least one phase-change layer 113 are stacked alternately or arranged periodically, and n periodic repeated stacking may be formed starting from the chalcogenide layer 115 and ending at the phase-change layer 113. n is an integer greater than or equal to 1. n is an integer greater than or equal to 1.

In another illustrative example of Embodiment b, with reference to FIG. 8C, in a direction from the electrode 111 to the electrode 112, the at least one chalcogenide layer 115 and the at least one phase-change layer 113 are stacked alternately or arranged periodically. This may start from the phase-change layer 113 and end at the phase-change layer 113. Between a phase-change layer 113 at a start location and a phase-change layer 113 at an end location, there are n periodically and repeatedly stacked chalcogenide layers 115 and phase-change layers 113. In addition, in the phase-change memory cell 110, at least one chalcogenide layer 115 is between the two phase-change layers 113, and at least one phase-change layer is between two chalcogenide layers 115. n is an integer greater than or equal to 1. n is an integer greater than or equal to 1.

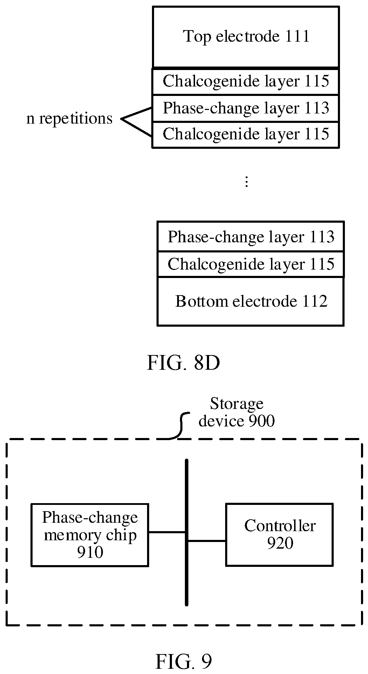

In another illustrative example of Embodiment b, with reference to FIG. 8D, in a direction from the electrode 111 to the electrode 112, the at least one chalcogenide layer 115 and the at least one phase-change layer 113 are stacked alternately or arranged periodically. This may start from the chalcogenide layer 115 and end at the chalcogenide layer 115. Between a chalcogenide layer 115 at a start location and a chalcogenide layer 115 at an end location, there are n periodically and repeatedly stacked phase-change layers 113 and chalcogenide layers 115. In addition, in the phase-change memory cell 11, at least one chalcogenide layer 115 is between two phase-change layers 113, and at least one phase-change layer is between the two chalcogenide layers 115. n is an integer greater than or equal to 1. n is an integer greater than or equal to 1.

The foregoing uses the structures shown in FIG. 8A to FIG. 8D as examples to describe a location relationship between the phase-change layer 113 and the chalcogenide 115, but the examples are not exhaustive. In another embodiment, the phase-change layer 113 and the chalcogenide layer 115 may alternatively have another location relationship. Details are not listed one by one herein.

Refer to FIG. 9. An embodiment of this application provides a storage device 900, including a phase-change memory chip 910 and a controller 920. The phase-change memory chip 910 may be configured to store data, and the controller 920 may be configured to write data into the phase-change memory chip 910 or read data from the phase-change memory chip 910. The phase-change memory chip 910 may include a plurality of phase-change memory cells 110, and the plurality of phase-change memory cells 110 form a memory cell array in the storage device 900.

In some embodiments, the phase-change memory chip 910 may be implemented with reference to the foregoing descriptions of the embodiment shown in FIG. 2. The controller 920 may be a device having a data processing capability, and is configured to control a peripheral circuit of the phase-change memory chip 910, to write data into the phase-change memory chip 910 or read data from the phase-change memory chip 910.

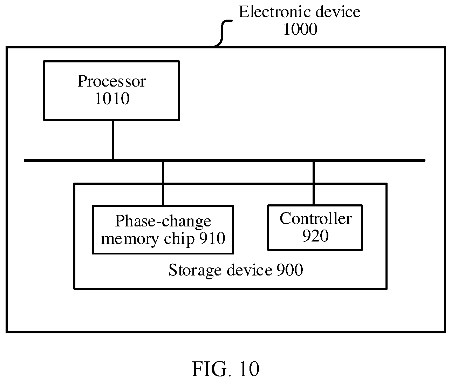

Refer to FIG. 10. An embodiment of this application provides an electronic device 1000. The electronic device 1000 may include a processor 1010 and a storage device 900. The storage device 900 may be configured to store data, for example, may store an application and a configuration file of the electronic device 1000. The storage device 900 may provide data storage space for the processor 1010, so that the processor 1010 can write data into the data storage space. Data stored in the storage device 900 may be read or invoked by the processor 1010. The processor 1010 is configured to write data into the storage device 900 or read data from the storage device 900. Specifically, the processor 1010 may write data into a phase-change memory chip 910 or read data from a phase-change memory chip 910 through a controller 920. For example, the processor 1010 may invoke data in the storage device 900, to implement a corresponding function of the electronic device 1000.

In some embodiments, the storage device 900 may be used as a memory (memory) of the electronic device 1000. In some embodiments, the storage device 900 may be used as an external memory of the electronic device 1000. In some embodiments, the processor 1010 may be a neural-network processing unit (neural-network processing unit, NPU). In some embodiments, the storage device 900 may alternatively be another form of apparatus that has a data storage capability and that is in the electronic device 1000. An implementation of the storage device 900 is not specifically limited in this application.

In some embodiments, the processor 1010 may be a central processing unit (central processing unit, CPU). In some embodiments, the processor 1010 may be a graphics processing unit (graphics processing unit, GPU). In some embodiments, the processor 1010 may be an application-specific integrated circuit (application-specific integrated circuit, ASIC). In some embodiments, the processor 1010 may be a neural-network processing unit (neural-network processing unit, NPU). In some embodiments, the processor 1010 may alternatively be another form of apparatus that has a data processing capability and that is in the electronic device 100. An implementation of the processor 1010 is not specifically limited in this application.

In some embodiments, the electronic device 1000 may be a server, a mobile terminal (for example, a mobile phone, a tablet computer, or a notebook computer), a vehicle-mounted terminal, or the like. An implementation of an electronic device in which the processor 1010 and the storage device 900 are located is not specifically limited in this embodiment of this application.

It may be understood that the foregoing embodiments are merely intended for describing the technical solutions of this application, but not for limiting this application. Although this application is described in detail with reference to the foregoing embodiments, a person of ordinary skill in the art should understand that modifications to the technical solutions recorded in the foregoing embodiments or equivalent replacements to some technical features thereof may still be made; and these modifications or replacements do not make the essence of the corresponding technical solutions depart from the scope of the technical solutions in embodiments of this application.

The foregoing descriptions are merely specific implementations of this application, but are not intended to limit the scope of the protection of this application. Any variation or replacement readily figured out by a person skilled in the art within the technical scope disclosed in the present invention shall fall within the scope of the protection of this application. Therefore, the scope of the protection of this application shall be subject to the scope of the protection of the claims.

## Claims

1. A phase-change memory material, wherein the phase-change memory material comprises a material shown by a formula (1):
TiₐSb_{b}Te_{c}D_{d} (1),
wherein
a represents an atom percent of Ti, b represents an atom percent of Sb, c represents an atom percent of Te, d represents an atom percent of an element D, and a+b+c+d=1;
3%≤a≤45%, and 0.5≤(b:c)≤3; and
D is a doping element, and 0≤d≤15%.

2. The phase-change memory material according to claim 1, wherein a value range of the atom percent a of Ti is 20%≤a≤35%.

3. The phase-change memory material according to claim 1 or 2, wherein a ratio of the atom percent b of Sb to the atom percent c of Te is 2:3.

4. The phase-change memory material according to any one of claims 1 to 3, wherein the atom percent d of the doping element D is 3%≤d≤8%.

5. The phase-change memory material according to any one of claims 1 to 4, wherein the doping element comprises one or a combination of at least two of a first non-metallic element, a first metallic element, and a telluride of the first metallic element, wherein
the first non-metallic element is one or a combination of at least two of C, O, N, and Si; and
the first metallic element is one or a combination of at least two of Zr, Cr, Al, Sc, Y, Ta, Hf, Er, In, Ge, Ga, and Sn.

6. A preparation method of a phase-change memory material, wherein the method is used to prepare the phase-change memory material according to any one of claims 1 to 5, and the method comprises:
preparing the phase-change memory material in a first deposition manner according to an element proportion shown by a formula (1), wherein the first deposition manner belongs to one of chemical vapor deposition CVD, physical vapor deposition PVD, and atomic layer deposition ALD, wherein
TiₐSb_{b}Te_{c}D_{d} (1),
wherein
a represents an atom percent of Ti, b represents an atom percent of Sb, c represents an atom percent of Te, d represents an atom percent of an element D, and a+b+c+d=1;
3%≤a≤45%, and 0.5≤(b:c)≤3; and
D is a doping element, and 0≤d≤15%.

7. A phase-change memory chip, comprising a plurality of memory cells, wherein the plurality of memory cells form a memory cell array, and each memory cell comprises: a phase-change layer, a first electrode located on one side of the phase-change layer, and a second electrode located on another side of the phase-change layer, wherein the phase-change layer is made of the phase-change memory material according to any one of claims 1 to 5.

8. The phase-change memory chip according to claim 7, wherein each memory cell further comprises a buffer layer in contact with the phase-change layer, wherein the buffer layer is made of one of carbon, a third metal, a nitride of the third metal, and a telluride of a fourth metal; and the third metal is one or a combination of at least two of W, Ta, and Ti, and the fourth metal is one or a combination of at least two of Zr, Cr, Al, Sc, Y, Ta, Hf, Er, In, Ge, Bi, Ti, Ga, and Sn.

9. The phase-change memory chip according to claim 7 or 8, wherein each memory cell further comprises at least one phase-change layer and at least one chalcogenide layer, wherein both the at least one phase-change layer and the at least one chalcogenide layer are located between the first electrode and the second electrode, and the at least one phase-change layer and the at least one chalcogenide layer are stacked alternately.

10. The phase-change memory chip according to claim 9, wherein a lattice coefficient of the chalcogenide layer is less than a lattice coefficient of SbTe.

11. A storage device, wherein the storage device comprises a controller and the phase-change memory chip according to any one of claims 9 and 10, the phase-change memory chip is configured to store data, and the controller is configured to write data into the phase-change memory chip or read data from the phase-change memory chip.

12. An electronic device, comprising a processor and the storage device according to claim 11, wherein the storage device is configured to store data, and the processor is configured to write data into the storage device or read data from the storage device.
